(19) Europäisches Patentamt European Patent Office Office européen des brevets

(11) **EP 4 502 524 A1**

(12) **EUROPEAN PATENT APPLICATION**

(43) Date of publication:
**05.02.2025 Bulletin 2025/06**

(21) Application number: **24179445.2**

(22) Date of filing: **31.05.2024**

(51) International Patent Classification (IPC):
**F28D 20/02** $^{(2006.01)}$        **F28D 15/02** $^{(2006.01)}$

(52) Cooperative Patent Classification (CPC):
**F28D 15/025; B01D 53/00; F28D 15/0275;
F28D 20/02; F28F 13/003**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.08.2023 US 202363516950 P
28.05.2024 US 202418675964**

(71) Applicant: **ROCKY RESEARCH
Boulder City, NV 89005 (US)**

(72) Inventor: **ABUHEIBA, Ahmed
Charlotte, 28202 (US)**

(74) Representative: **Haseltine Lake Kempner LLP
Cheapside House
138 Cheapside
London EC2V 6BJ (GB)**

(54) **SYSTEM AND METHOD FOR DISSIPATING HEAT**

(57)    A system for dissipating heat from a component includes a heat pipe assembly and an adsorption bed. The heat pipe assembly may include a pair of walls defining an inter-wall volume between opposing faces of the pair of walls. The heat pipe assembly may be configured to be thermally coupled to the component such that the pair of walls extends away from the component. The adsorption bed may at least partially occupy the inter-wall volume. The adsorption bed may include an adsorbent medium and a phase change material. The phase change material is configured to dissipate heat away from the component by a phase change from a first phase to a second phase.

FIG. 1A

EP 4 502 524 A1

## Description

### CROSS-REFERENCE TO RELATED APPLICATIONS

This application claims the benefit of U.S. Provisional Patent Application 63/516,950, filed August 1, 2023, the entire contents of which are incorporated herein by reference.

### STATEMENT REGARDING FEDERALLY SPONSORED RESEARCH OR

### DEVELOPMENT

This invention was made with Government support under WO W900KK-21-9-0016 awarded by Department of Defense (DOD). The Government has certain rights in the invention.

### TECHNICAL FIELD

The present disclosure relates to systems and techniques for dissipating heat, for example, from a heat-generating component.

### BACKGROUND

Certain components, devices, or systems may generate a relatively large amount of heat in relatively short time periods. For example, vehicles or moving objects may generate a relatively large heat flux. The heat flux may have an order of magnitude as high as $10^1$ $W/cm^2$ or even $10^2$ $W/cm^2$. Such heat flux may need to be dissipated, for example, to the ambient environment, so that the heat-generating components, devices, or systems do not overheat beyond a threshold temperature.

### SUMMARY

In general, the present disclosure describes systems and techniques for dissipating heat, for example, away from a component. The component may be any heat-generating component.

In some examples, the present disclosure describes a system for dissipating heat from a component. The system includes a heat pipe assembly and an adsorption bed. The heat pipe assembly may include a pair of walls defining an inter-wall volume between opposing faces of the pair of walls. The heat pipe assembly may be configured to be thermally coupled to the component such that the pair of walls extends away from the component. The adsorption bed may at least partially occupy the inter-wall volume. The adsorption bed may include an adsorbent medium and a phase change material. The phase change material may be configured to dissipate heat away from the component by a phase change from a first phase to a second phase.

In some examples the present disclosure describes an assembly including a component configured to generate heat; and a system thermally coupled to the component and configured to dissipate heat from the component. The system may include a heat pipe assembly including a pair of walls defining an inter-wall volume between opposing faces of the pair of walls. The heat pipe assembly is configured to be thermally coupled to the component such that the pair of walls extends away from the component. The system may further include an adsorption bed at least partially occupying the inter-wall volume. The adsorption bed may include an adsorbent medium and a phase change material. The phase change material is configured to dissipate heat away from the component by a phase change from a first phase to a second phase.

In some examples, the present disclosure describes a method including forming a heat pipe assembly. The heat pipe assembly may include a pair of walls defining an inter-wall volume between opposing faces of the pair of walls. The heat pipe assembly is configured to be thermally coupled to a component such that the pair of walls extends away from the component. The method further includes introducing an adsorption bed that at least partially occupies the inter-wall volume. The adsorption bed may include an adsorbent medium loaded with a phase change material. The phase change material may be configured to dissipate heat away from the component by a phase change from a first phase to a second phase.

The details of one or more examples are set forth in the accompanying drawings and the description below. Other features, objects, and advantages will be apparent from the description and drawings, and from the claims.

### BRIEF DESCRIPTION OF THE FIGURES

The details of one or more examples are set forth in the accompanying drawings and the description below. Other features, objects, and advantages will be apparent from the description and drawings, and from the claims.

FIG. 1A is a diagram showing a front view of a system for dissipating heat from a component.
FIG. 1B is a diagram showing a top view of the system of FIG. 1A.
FIG. 1C is a diagram showing a side view of the system of FIG. 1A.
FIG. 2 is a diagram showing a side view of a system for dissipating heat from a component, including walls of varying width.
FIG. 3A is a diagram showing a front view of the system of FIG. 1A in a first heated configuration in which the temperature is insufficient to activate the heat pipe.
FIG. 3B is a diagram showing a front view of the system of FIG. 1A in a second heated configuration in which the temperature is sufficient to activate the heat pipe.

FIG. 3C is a diagram showing a front view of the system of FIG. 1A in a third heated configuration in which the adsorption bed is further heated in absence of the phase change material.

FIG. 4A is a schematic diagram representing an uncontrolled heat transfer away from a component associated with a mass flow rate that decreases in a direction away from the component.

FIG. 4B is a schematic diagram representing a controlled heat transfer away from a component associated with a mass flow rate that remains uniform in a direction away from the component.

FIG. 5 is a chart comparing temperature distributions in adsorption beds with uncontrolled and controlled heat transfer.

FIG. 6 is a flowchart representing a method for forming a system for dissipating heat from a component.

## DETAILED DESCRIPTION

In general, the disclosure describes systems and techniques for dissipating heat, for example, from a heat-generating component. In some examples, the component may include high-power electronics that generate a relatively large amount of heat. However, systems and techniques according to the present disclosure may be used to dissipate heat from any component that generates heat from a different source.

In some examples, the present disclosure describes a system for dissipating heat from a component. The system may include a heat pipe assembly and an adsorption bed. The heat pipe assembly may include a pair of walls defining an inter-wall volume between opposing faces of the pair of walls. The heat pipe assembly may be configured to be thermally coupled to the component such that the pair of walls extends away from the component. The adsorption bed may at least partially occupy the inter-wall volume. The adsorption bed may include an adsorbent medium and a phase change material. The phase change material may be configured to dissipate heat away from the component by a phase change from a first phase to a second phase. For example, the first phase may be low temperature phase (e.g., a solid), and the second phase may be a high temperature phase (e.g., a liquid or a vapor). In other examples, the first phase is a liquid, and the second phase may be a gas.

In some examples, the phase change material may be configured to be held within the adsorption bed in the first phase, for example, within or onto the adsorbent medium. In the second phase, the phase change material may be configured to depart or leave from the adsorption bed into the ambient environment. For example, the phase change material may be a liquid held in the adsorption bed in the first phase, and a vapor or gas that transports from the adsorption bed to the ambient environment. Thus, as the heat pipe assembly continues to transfer heat from the component to the adsorption bed, the phase change material may progressively change state, such that eventually an entirety of the phase change material is in the second phase.

Using a heat pipe assembly may promote control of heat transfer and more uniform mass flow, allowing a relatively uniform heat dissipation as the component continues to generate heat, until an entirety of the phase change material is in the second phase. In some examples, the heat pipe assembly includes an oscillating heat pipe (also known as a pulsating heat pipe), in which volumes or packets of working fluid are repeatedly transferred between a hot section and a cold section along a closed thermal circuit. Using an oscillating heat pipe may also promote uniformity of heat transfer and mass flow, for example, by transferring heat uniformly at different locations along the adsorption bed.

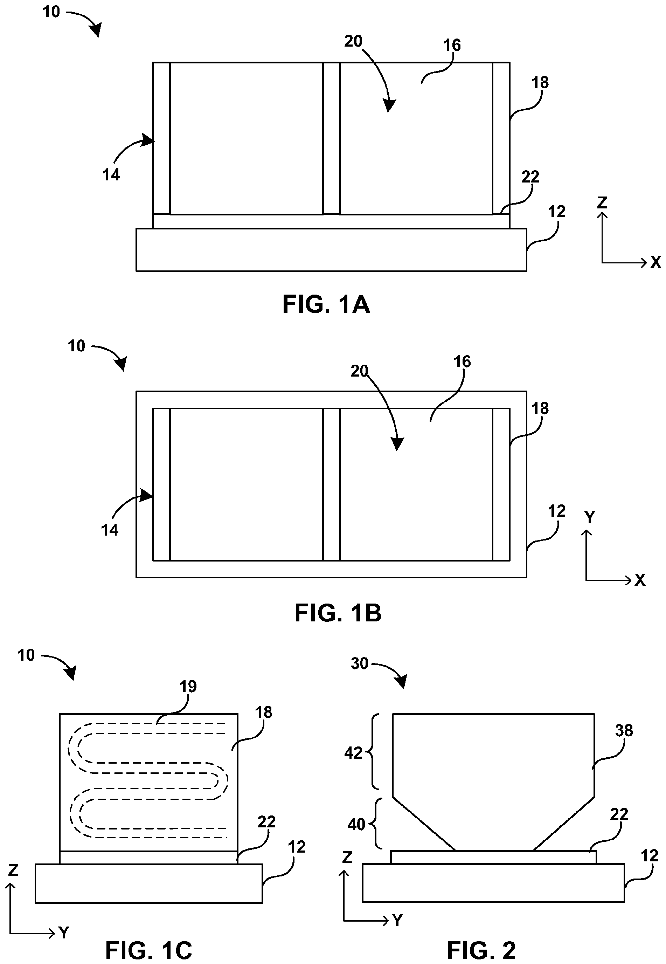

FIG. 1A is a diagram showing a front view of a system 10 for dissipating heat from a component 12. FIG. 1B is a diagram showing a top view of system 10 of FIG. 1A. FIG. 1C is a diagram showing a side view of system 10 of FIG. 1A.

Component 12 may include a heat-generating component, for example, a vehicle, a moving object, or a projectile.

System 10 includes a heat pipe assembly 14 and an adsorption bed 16. Heat pipe assembly 14 may include a pair of walls 18 defining an inter-wall volume 20 between opposing faces of the pair of walls. Heat pipe assembly 14 may include one or more of a metal, an alloy, a ceramic, or any other suitable material. At least a portion of heat pipe assembly 14, for example, walls 18, includes a working fluid. The working fluid is confined to flow within an interior of heat pipe assembly, for example, through one or more channels or conduits. In some examples, heat pipe assembly 14 includes an oscillating heat pipe. For example, heat pipe assembly 14 may include at least one undulating or serpentine channel through which one or more volumes or packets of working fluid repeatedly flow in different phases (for example, liquid and vapor phases) between a hot end and a cold end to transfer heat from the hot end to the cold end. For example, each wall of pair of walls 18 may include at least one undulating channel 19, which may include a two-phase working fluid. The volumes or packets may repeatedly change phase between the first phase and second phase as they circulate through the undulating or serpentine channel between the hot and cold ends.

Heat pipe assembly 14 may be configured to be thermally coupled to component 12 such that the pair of walls 18 extend away from component 12. For example, at least one surface or portion of heat pipe assembly 14 may be in direct contact (touching surfaces that transfer heat) or indirect contact (with one or more intermediate layers or components that transfer heat).

Adsorption bed 16 may at least partially occupy inter-wall volume 20. For example, less than half, half, or more than half of inter-wall volume 20 may be occupied by adsorption bed 16. Adsorption bed 16 may include an adsorbent medium and a phase change material. The phase change material may be configured to dissipate heat away from the component by a phase change between a first phase to a second phase. The phase change material may be the same as or different from the working fluid within heat pipe assembly 14. However, while the working fluid within heat pipe assembly 14 is part of a closed thermal system and recirculates within an interior of heat pipe assembly 14, the phase change material in adsorption bed 16 is part of an open system and is exposed to the ambient. Thus, unlike the working fluid, increasing portions or volumes of the phase change material initially in adsorption bed 16 is transferred away from heat adsorption bed 16 to the ambient environment, as heat transfer continues from component 12 to heat pipe assembly 14.

The phase change material may be configured to absorb heat to change phase from the first phase to the second phase. In some examples, the first phase is liquid and the second phase is vapor. In some examples, the first phase is solid and the second phase is liquid or vapor. For example, the phase change material may directly sublimate from solid to vapor phase, or convert from solid to vapor via an intermediate liquid phase. In some examples, the first phase is solid and the second phase is liquid, such that phase change material departs from adsorption bed 16 into the ambient environment as droplets or streams of liquid.

Thus, heat pipe assembly 14 may absorb heat from component 12 and distribute it in a controlled manner along a height of adsorption bed 16 (for example, from a bottom near component 12 to a top away from component 12). As the temperature of adsorption bed 16 increases, the saturation pressure of the phase change material increases above ambient pressure. The phase change material absorbs heat equal to its latent heat of vaporization from adsorption bed 16, and starts to depart adsorption bed 16 to the ambient, for example, as vapor. Because the latent heat of vaporization is high relative to sensible heat, a large cooling effect results compared to heat transfer by conduction. Thus, the phase change material may act as a refrigerant that transfers heat away from component 12.

Heat pipe assembly 14 conducts heat through another phase change, a phase change of its working fluid. Therefore, it only conducts heat when its working fluid is above an activation temperature. The activation temperature depends on the nature of the working fluid, and the initial charge pressure of heat pipe assembly 14. Heat pipe assembly 14 has a relatively high thermal conductivity compared to a purely conductive structure. For example, heat pipe assembly 14 may have a thermal conductivity on the order of 104 W/m-K. Because of the high thermal conductivity, when heated, and the temperature of the working fluid is above its activation temperature, the entire heat pipe assembly 14 is at a uniform temperature. Such a uniform temperature promotes a uniform mass flow and heat transfer through adsorption bed 16.

The adsorbent medium in adsorption bed 16 may be any suitable material configured to retain the phase change material in the first phase. For example, the phase change material in the first phase may be retained within a matrix of the adsorbent medium, or on an exterior surface of the adsorbent medium, or within pores of the adsorbent medium, or between interstices defined by opposing surfaces of the adsorbent medium. In some examples, the adsorbent medium includes a porous substrate. For example, the porous substrate comprises at least one of a woven substrate, a non-woven substrate, or a sintered substrate. The adsorbent medium comprises at least one of a metal, an alloy, a ceramic, a glass, a silicate, a nitride, or graphite.

As shown in FIG. 1C, in some examples, each wall of the pair of walls 18 defines a uniform width in a direction between respective ends of the wall. For example, walls 18 may have a uniform width in a direction pointing away from component 12.

In some examples, heat pipe assembly 14 includes a plurality of walls including the pair of walls 18. Thus, heat pipe assembly may include two, three, or more walls.

In other examples, for example, as described with reference to FIG. 2, a wall may have a varying width.

FIG. 2 is a diagram showing a side view of a system 30 for dissipating heat from a component, including walls of varying width. System 30 is substantially similar to system 10, but differing in the presence of walls 38. Walls 38 are similar to walls 18 of system 10, but differ in having a varying width. In particular, walls 38 define a varying width in a direction between respective ends of the wall, in a direction extending away from component 12. In some examples, each wall 38 increases in width in a section 40 in a direction extending away from a first end of the wall configured to face component 12. In some examples, each wall 38 has another section 42 in which the width varies in a different manner than in section 40, or is constant, in the direction extending away from the first end of the wall configured to face component 12, as shown in FIG. 2. The increase in width may be linear or nonlinear.

In some examples, heat pipe assembly 14 further includes a base 22 configured to be thermally coupled to component 12. Base 22 may have any suitable shape or size, and may be formed of any material or construction described with reference to heat pipe assembly 14, the pair of walls secured to and extending away from base 22. In some examples, base 22 defines a rectangular edge.

In some examples, undulating channel 19 extends continuously through base 22 and each of walls 18. For example, respective sub-channels extending through base 22 and each of walls 18 may be fluidically coupled to define a single fluidic circuit. In some examples, base 22 may not include any channel, and may instead transfer heat to walls 18 by bulk conduction. In some examples, base 22 may include a first heat pipe, and walls 18 may include one or more second heat pipes. Thus, heat pipe assembly 14 may include two or more heat pipes that are fluidically coupled or that provide separate conductive paths.

In some examples, heat pipe assembly 14 further comprises a housing defining an open interior (not shown in the figures). For example, the open interior may include an opening facing away from component 12, such that phase change material may depart heat pipe assembly 14 from the opening. The open interior may include the pair of walls 18 and adsorption bed 16. For example, adsorption bed 16 may be housed between walls 18 in the housing. The housing may include any material described with reference to heat pipe assembly 14. In some examples, one or more walls 18 form the housing.

In some examples, an assembly includes component 12 configured to generate heat; and system 10 or 30.

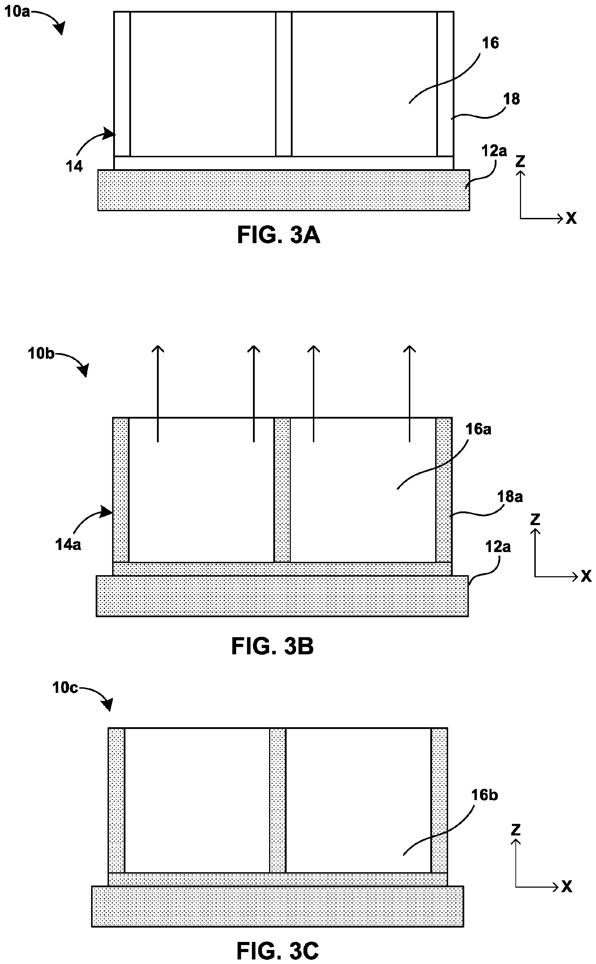

Thus, the shape of the walls may be modified provide varying heat transfer resistance along the vertical direction, while maintaining the temperature substantially constant. Therefore, the heat transfer to the adsorbent along the vertical direction can be controllably varied based on the shape, number, and spacing of walls. Heat transfer at different thermal regimes (as heat generated by a component increases) is further described with reference to FIGS. 3A to 3C.

FIG. 3A is a diagram showing a front view of the system of FIG. 1A in a first heated configuration 10a in which the temperature is insufficient to activate heat pipe assembly 14. In configuration 10a, component 12 is heated to configuration 12a, but heat pipe assembly 14 is substantially at an initial temperature because the working fluid within heat pipe assembly 14 is not activated.

When component 12 (or any heat source transferring heat to the system) is active, the temperature of component 12 increases gradually, for example, to heated configuration 12a. While the temperature of component 12a is lower than the activation temperature of the phase change material, heat pipe assembly 14 does not conduct heat and is at a uniform temperature close to the temperature of the adsorbent. Thus, while the temperature of component 12a is lower than the activation temperature of the phase change material, heat substantially remains in component 12a, as shown in FIG. 3A, and is not transferred to heat pipe assembly 14.

FIG. 3B is a diagram showing a front view of the system of FIG. 1A in a second heated configuration 10b in which the temperature is sufficient to activate heat pipe assembly 14. In this configuration, because the temperature of component 12 meets the activation criterion for the working fluid in heat pipe assembly 14, the temperature of heat pipe assembly 14 uniformly increases to nearly the temperature of component 12. Thus, heat pipe assembly 14 now is in a second configuration 14a, being heated. In turn, adsorption bed 16a is heated, leading to conversion of the phase change material from the first phase to the second phase, and a portion of the phase change material departs in the second phase (for example, as a vapor) from adsorption bed 16a.

Because of controlled heat transfer along the height of wall 18 (now in a heated configuration 18a), a relatively low difference in temperature between the bottom and the top of adsorption bed 16 is maintained. Since the partial pressure of the phase change material in adsorption bed 16 is directly proportional to temperature, the difference in the phase change material (refrigerant) partial pressure across adsorption bed 16 is small. Because the pressure difference is low, the mass flow rate of the phase change material along the length of adsorption bed 16 is uniform. The uniformity of the mass flow promotes removal of heat and avoids or reduces accumulation of heat toward the bottom layers. Such uniformity results in a high flow rate of the phase change material, that is directly proportional to the cooling effect of adsorption bed 16. Such uniformity also results in a nearly constant heat transfer rate over the entire cooling period.

FIG. 3C is a diagram showing a front view of the system of FIG. 1A in a third heated configuration 10c in which adsorption bed 16 is further heated in absence of the phase change material (having completely departed adsorption bed 16) to a configuration 16b. With substantially an entire volume of the phase change material having migrated to the ambient environment, adsorption bed 16b is "dry," and provides no more cooling. Accordingly, the temperature of adsorption bed 16b gradually increases.

One or more of the nature and amount of the phase change material, dimensions and operating parameters of heat pipe assembly 14, the working fluid in heat pipe assembly 14, the dimensions and arrangement of walls 18, or of base 22, may be adjusted to provide a sufficient cooling for component 12 before adsorption bed 16 reaches final configuration 16b.

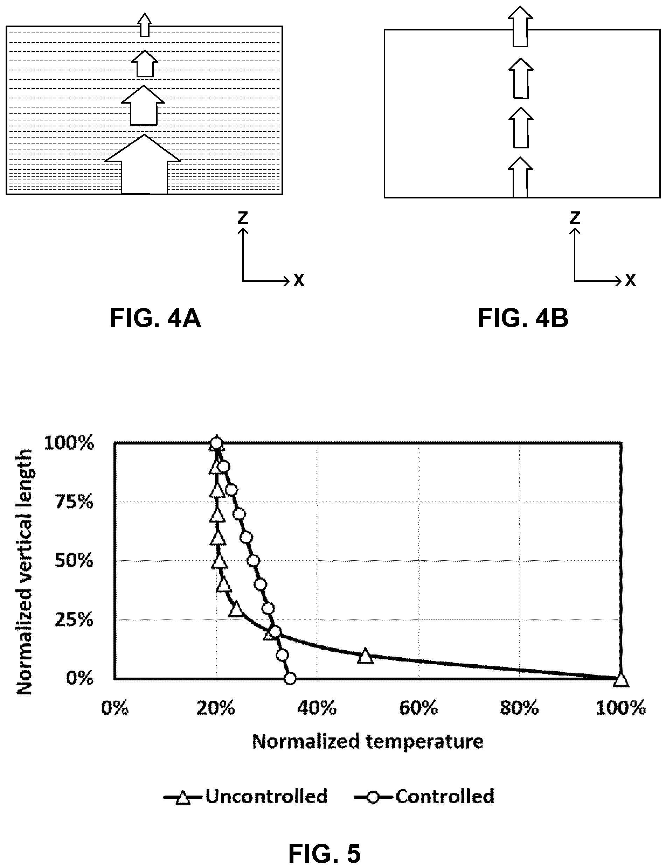

The effect of controlling heat transfer along the length of an adsorption bed is discussed with reference to FIGS. 4A (controlled heat transfer) and 4B (controlled heat transfer).

FIG. 4A is a schematic diagram representing an uncontrolled heat transfer away from a component associated with a mass flow rate that decreases in a direction away from the component. In the uncontrolled case of FIG. 4A, heat is transferred in series from the bottom layer (adjacent a heat-generating component) to the top layer of the bed (away from the component). Each layer becomes warmer than the one above it. The temperature difference results in a saturation pressure difference. The phase change material (refrigerant) in the bottom layer in turn tries to "push" its way into the layer above. Because the layer above has its own refrigerant, only a small volume of refrigerant can force its way into the layer above. Such transfer is repeated between pairs of consecutive layers, so material in the bottom-most layer must push relatively much harder to advance. Such a difference of transfer results in exponential temperature and pressure distribution, in which differences between the bottom layer and the top layer are relatively large.

FIG. 4B is a schematic diagram representing a controlled heat transfer away from a component associated with a mass flow rate that remains uniform in a direction away from the component. In the controlled case of FIG. 4B, all layers are being heated simultaneously. Thus, the phase change material (refrigerant) starts to leave the topmost layer into the ambient environment from the start of cooling. A volume of material that departs one layer is being replenished substantially instantaneously from the layer below. Therefore, the refrigerant in each layer must push only slightly to move to the next layer. Such an "orderly" mass transfer maintains small temperature and pressure difference between the top and the bottom layer. Thus, compared to the uncontrolled heat transfer case of FIG. 4B, the mass flow rate is more uniform in the controlled heat transfer case of FIG. 4A.

FIG. 5 is a chart comparing temperature distributions in adsorption beds with uncontrolled and controlled heat transfer. The chart of FIG. 5 is based on a numerical analysis of heat transfer control. Identical heat transfer may be maintained for a finite time length in simulations of both a controlled and an uncontrolled adsorption bed, so that equal amount of thermal energy is transferred to each. To generalize the comparison, the topmost layers of both beds are held at the same temperature in both simulations. The temperature distribution along the bed must be so that the spatial integration of the temperature is the same for each bed. If the temperature distribution is known, both cases can be compared.

In the uncontrolled bed, each layer must do progressively more work since it must push itself and the refrigerant in all the layers above it. Therefore, the profile would exponentially increase toward the bottom. In the controlled bed, the refrigerant in each layer must only push itself. Therefore, the profile would be linear.

As shown in FIG. 5, the integral of temperature with respect to distance (area under each curve) is numerically equal for both cases. For generality, the temperature and the length of the bed are normalized by the same factor in both cases. To absorb the same amount of thermal energy, the uncontrolled bed must operate at a much higher spatially weighted average temperature than the controlled.

In steady state and assuming no heat is lost from the bed to surroundings, 100% of the absorbed thermal energy will be converted to flow energy. The flow energy is directly proportional to pressure and to the mass flow rate, as represented by EQUATION 1.

$$E_{flow} \propto \frac{m}{\rho} \Delta P \text{ (Equation 1)}$$

From the above proportionality, EQUATION 2 relates a mass flow ratio to a pressure differential ration.

$$\frac{m_{linear}}{m_{exponential}} = \frac{\Delta P_{exponentail}}{\Delta P_{linear}} \text{ (Equation 2)}$$

The ratio of pressures is directly related to the rate of change of saturation pressure with respect to temperature. For several potential working fluids, this ratio is on the order of $10^3$ or higher. For example, for water and for acetone, the rate of change in saturation pressure with respect to temperature is on the order of $10^4$ Pa between 50 and 200 °C.

Because the refrigerant does not have to travel serially from one layer to the next, the bed may be made to any suitable length, with a relatively low or negligible effect of the pressure differential across the bottom and top layers. Therefore, the bed can be made much larger, providing large reservoir of cooling energy at high heat flux, compared to beds with uncontrolled heat transfer.

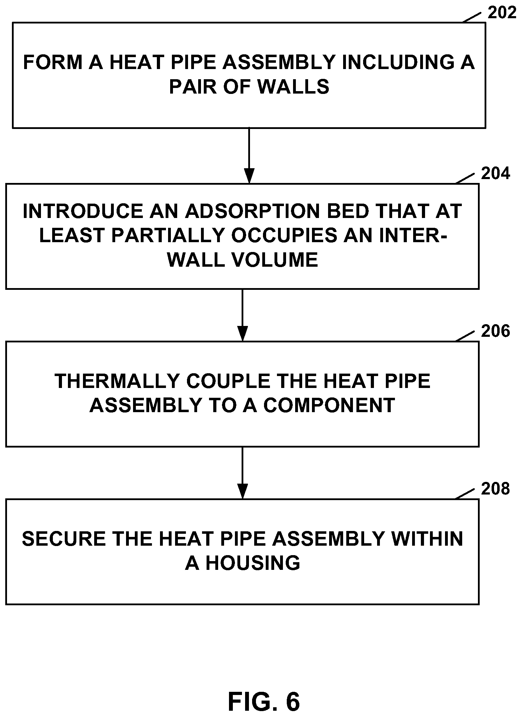

FIG. 6 is a flowchart representing a method for forming a system for dissipating heat from a component. The method may include forming a heat pipe assembly (202). The heat pipe assembly may include a pair of walls defining an inter-wall volume between opposing faces of the pair of walls. The heat pipe assembly is configured to be thermally coupled to a component such that the pair of walls extends away from the component. The method further includes introducing an adsorption bed that at least partially occupies the inter-wall volume (204). The adsorption bed may include an adsorbent medium loaded with a phase change material. The phase change material may be configured to dissipate heat away from the component by a phase change between a first phase and a second phase.

In some examples, the method further includes thermally coupling the heat pipe assembly to the component (206).

In some examples, forming the heat pipe assembly (202) includes securing the pair of walls to a base. In some such examples, the method further includes thermally coupling the base to the component.

In some examples, the method further includes securing the heat pipe assembly within a housing (208).

The following enumerated clauses describe various examples according to the present disclosure.

Clause 1: A system for dissipating heat from a component, the system including: a heat pipe assembly including a pair of walls defining an inter-wall volume between opposing faces of the pair of walls, the heat pipe assembly being configured to be thermally coupled to the component such that the pair of walls extends away from the component; and an adsorption bed at least partially occupying the inter-wall volume, the adsorption bed including an adsorbent medium and a phase change material, the phase change material being configured to dissipate heat away from the component by a phase change from a first phase to a second phase.

Clause 2: The system of clause 1, where the first phase is liquid and the second phase is vapor.

Clause 3. The system of clause 1, where the first phase is solid and the second phase is liquid or vapor.

Clause 4. The system of any of clauses 1 to 3, where the adsorbent medium includes a porous substrate.

Clause 5. The system of clause 4, where the porous substrate includes at least one of a woven substrate, a non-woven substrate, or a sintered substrate.

Clause 6. The system of any of clauses 1 to 5, where the adsorbent medium includes at least one of a metal, an alloy, a ceramic, a silicate, a nitride, or graphite.

Clause 7. The system of any of clauses 1 to 6, where the heat pipe assembly includes an oscillating heat pipe.

Clause 8. The system of clause 7, where each wall of the pair of walls includes at least one undulating channel including a two-phase working fluid.

Clause 9. The system of any of clauses 1 to 8, where each wall of the pair of walls defines a uniform width in a direction between respective ends of the wall.

Clause 10. The system of any of clauses 1 to 8, where each wall of the pair of walls defines a varying width in a direction between respective ends of the wall.

Clause 11. The system of clause 10, where each wall increases in width in a section extending away from a first end of the wall configured to face the component.

Clause 12. The system of any of clauses 1 to 11, where the heat pipe assembly includes a plurality of walls including the pair of walls.

Clause 13. The system of any of clauses 1 to 12, where the heat pipe assembly further includes a base configured to be thermally coupled to the component, the pair of walls secured to and extending away from the base.

Clause 14. The system of any of clauses 1 to 13, where the heat pipe assembly further includes a housing defining an open interior, where the open interior includes the pair of walls and the adsorption bed.

Clause 15. An assembly including:

a component configured to generate heat; and
the system of any of clauses 1 to 14 thermally coupled to the component.

Clause 16. A method including: forming a heat pipe assembly including a pair of walls defining an inter-wall volume between opposing faces of the pair of walls, the heat pipe assembly being configured to be thermally coupled to a component such that the pair of walls extends away from the component; and introducing an adsorption bed that at least partially occupies the inter-wall volume, the adsorption bed including an adsorbent medium loaded with a phase change material, the phase change material being configured to dissipate heat away from the component by a phase change from a first phase to a second phase.

Clause 17. The method of clause 16, further including thermally coupling the heat pipe assembly to the component.

Clause 18. The method of clauses 16 or 17, where forming the heat pipe assembly includes securing the pair of walls to a base.

Clause 19. The method of clause 18, further including thermally coupling the base to the component.

Clause 20. The method of any of clauses 16 to 19, further including securing the heat pipe assembly within a housing.

Various examples have been described. These and other examples are within the scope of the following claims.

## Claims

1. A system for dissipating heat from a component, the system comprising:

   a heat pipe assembly comprising a pair of walls defining an inter-wall volume between opposing faces of the pair of walls, the heat pipe assembly being configured to be thermally coupled to the component such that the pair of walls extends away from the component; and
   an adsorption bed at least partially occupying the inter-wall volume, the adsorption bed comprising an adsorbent medium and a phase change material, the phase change material being configured to dissipate heat away from the component by a phase change from a first phase to a second phase.

2. The system of claim 1, wherein the first phase is liquid and the second phase is vapor, or wherein the first phase is solid and the second phase is liquid or vapor.

3. The system of claims 1 or 2, wherein the adsorbent medium comprises a porous substrate.

4. The system of claim 3, wherein the porous substrate comprises at least one of a woven substrate, a non-woven substrate, or a sintered substrate.

5. The system of any of claims 1 to 4, wherein the adsorbent medium comprises at least one of a metal, an alloy, a ceramic, a silicate, a nitride, or graphite.

6. The system of any of claims 1 to 5, wherein the heat pipe assembly comprises an oscillating heat pipe, and wherein each wall of the pair of walls comprises at least one undulating channel comprising a two-phase working fluid.

7. The system of any of claims 1 to 6, wherein each wall of the pair of walls defines a uniform width in a direction between respective ends of the wall.

8. The system of any of claims 1 to 7, wherein each wall of the pair of walls defines a varying width in a direction between respective ends of the wall.

9. The system of claim 8, wherein each wall increases in width in a section extending away from a first end of the wall configured to face the component.

10. The system of any of claims 1 to 9, wherein the heat pipe assembly comprises a plurality of walls comprising the pair of walls.

11. The system of any of claims 1 to 10, wherein the heat pipe assembly further comprises a base configured to be thermally coupled to the component, the pair of walls secured to and extending away from the base.

12. The system of any of claims 1 to 11, wherein the heat pipe assembly further comprises a housing defining an open interior, wherein the open interior comprises the pair of walls and the adsorption bed.

13. An assembly comprising:

a component configured to generate heat; and a system thermally coupled to the component and configured to dissipate heat from the component, the system comprising:

a heat pipe assembly comprising a pair of walls defining an inter-wall volume between opposing faces of the pair of walls, the heat pipe assembly being configured to be thermally coupled to the component such that the pair of walls extends away from the component; and an adsorption bed at least partially occupying the inter-wall volume, the adsorption bed comprising an adsorbent medium and a phase change material, the phase change material being configured to dissipate heat away from the component by a phase change from a first phase to a second phase.

14. A method comprising:

forming a heat pipe assembly comprising a pair of walls defining an inter-wall volume between opposing faces of the pair of walls, the heat pipe assembly being configured to be thermally coupled to a component such that the pair of walls extends away from the component; and introducing an adsorption bed that at least partially occupies the inter-wall volume, the adsorption bed comprising an adsorbent medium loaded with a phase change material, the phase change material being configured to dissipate heat away from the component by a phase change from a first phase to a second phase.

15. The method of claim 14, further comprising thermally coupling the heat pipe assembly to the component.

**FIG. 1A**

**FIG. 1B**

**FIG. 1C**

**FIG. 2**

**FIG. 3A**

**FIG. 3B**

**FIG. 3C**

FIG. 4A

FIG. 4B

FIG. 5

202

FORM A HEAT PIPE ASSEMBLY INCLUDING A PAIR OF WALLS

204

INTRODUCE AN ADSORPTION BED THAT AT LEAST PARTIALLY OCCUPIES AN INTER-WALL VOLUME

206

THERMALLY COUPLE THE HEAT PIPE ASSEMBLY TO A COMPONENT

208

SECURE THE HEAT PIPE ASSEMBLY WITHIN A HOUSING

FIG. 6

Europäisches Patentamt

European Patent Office

Office européen des brevets

# EUROPEAN SEARCH REPORT

**Application Number**

EP 24 17 9445

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/368822 A1 (HOFACKER OLIVER [DE] ET AL) 5 December 2019 (2019-12-05) | 1-5, 11-15 | INV.<br>F28D20/02 |
| Y | * paragraphs [0039], [0045], [0011], | 7-12 | F28D15/02 |
| A | [0055]; claim 1; figures 1,2,3 * | 6 | |
| | ----- | | |
| Y | US 2018/090415 A1 (ESCOBAR-VARGAS SERGIO [US] ET AL) 29 March 2018 (2018-03-29) * paragraph [0031]; figures 2,5,6 * | 2,7,10, 12 | |
| | ----- | | |
| Y | DE 101 14 998 A1 (MERCK PATENT GMBH [DE]) 21 February 2002 (2002-02-21) * paragraph [0042]; figures 3,5 * | 2,7,10, 11 | |
| | ----- | | |
| Y | US 2021/010757 A1 (HACHIYA MAHIRO [JP] ET AL) 14 January 2021 (2021-01-14) * figures 10,16 * | 7-9 | |
| | ----- | | |

|  |
|---|
| **TECHNICAL FIELDS SEARCHED (IPC)** |
| F28D<br>H05K<br>F28F |

The present search report has been drawn up for all claims

| Place of search | Date of completion of the search | Examiner |
|---|---|---|
| Munich | 11 November 2024 | Martínez Rico, Celia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## EP 4 502 524 A1

### ANNEX TO THE EUROPEAN SEARCH REPORT
### ON EUROPEAN PATENT APPLICATION NO.

EP 24 17 9445

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2024

| Patent document cited in search report | Publication date | Patent family member(s) | Publication date |
|---|---|---|---|
| US 2019368822 A1 | 05-12-2019 | CN 110192076 A | 30-08-2019 |
| | | DE 102017200524 A1 | 19-07-2018 |
| | | EP 3551955 A1 | 16-10-2019 |
| | | US 2019368822 A1 | 05-12-2019 |
| | | WO 2018130367 A1 | 19-07-2018 |
| US 2018090415 A1 | 29-03-2018 | NONE | |
| DE 10114998 A1 | 21-02-2002 | DE 10114998 A1 | 21-02-2002 |
| | | KR 20010111034 A | 15-12-2001 |
| US 2021010757 A1 | 14-01-2021 | JP 7156368 B2 | 19-10-2022 |
| | | JP WO2019194089 A1 | 11-03-2021 |
| | | US 2021010757 A1 | 14-01-2021 |
| | | WO 2019194089 A1 | 10-10-2019 |

**EP 4 502 524 A1**

**Patent documents cited in the description**

- US 63516950